# EUROPEAN PATENT SPECIFICATION

(11) **EP 4 523 062 B1**
(45) Date of publication and mention of the grant of the patent: **03.06.2026**
(21) Application number: 23725485.9
(22) Date of filing: 24.04.2023
(51) Int. Cl.: G06F 1/16

(54) **UTILIZATION OF A FORCE SENSOR TO SIGNAL INTENT TO UNDOCK A DEVICE**
VERWENDUNG EINES KRAFTSENSORS ZUR SIGNALISIERUNG DER ABSICHT, EINE VORRICHTUNG ABDOCKEN ZU KÖNNEN
UTILISATION D'UN CAPTEUR DE FORCE POUR SIGNALER UNE INTENTION DE DÉTACHER UN DISPOSITIF

(30) Priority: 10.05.2022 US 202263364479 P
(43) Date of publication of application: 19.03.2025
(73) Proprietor: Google LLC, Mountain View, CA 94043 (US)
(72) Inventor: SANDERS, Nicholas, Mountain View, California 94043 (US); WIEDRICK, Roth, Mountain View, California 94043 (US); STANFORD, Scott, Mountain View, California 94043 (US); SAINI, Vivek, Mountain View, California 94043 (US); DE LA FUENTE, Valentin Shaun, Mountain View, California 94043 (US); FANTIN, Juan Manuel, Mountain View, California 94043 (US); CHANG, David F., Mountain View, California 94043 (US); PATEL, Prashant Bhogilal, Mountain View, California 94043 (US); BRUMMER, Bengt Gunnar, Mountain View, California 94043 (US); PI, Jason Stanley, Mountain View, California 94043 (US); WONG, Amy Lai, Mountain View, California 94043 (US)
(74) Representative: Maikowski & Ninnemann Patentanwälte Partnerschaft mbB
(86) International application number: PCT/US2023/019640
(87) International publication number: WO 2023/219784

(56) References cited:
- WO-A1-2014/049365
- US-A1- 2017 344 060

## Description

### CROSS-REFERENCE TO RELATED APPLICATIONS

This PCT Patent Application claims the benefit of U.S. Provisional Patent Application No. 63/364,479, entitled "DOCKABLE AND UNDOCKABLE MULTI-PURPOSE ELECTRONIC TABLET DEVICE," filed May 10, 2022.

### BACKGROUND

Tablet computing devices, sometimes referred to as tablets or as tablet computers, are generally planar, lightweight devices that include a touch-screen display. Tablets are battery powered and can be plugged in to recharge the tablet's battery.

WO2014049365 A1 discloses a mobile-computer support apparatus for docking a mobile computing device, which has a dock that is placed on stand, charging element that charges the mobile-computing device when docked and a locking mechanism that locks the mobile-computing device to dock.

### SUMMARY

The invention is set out in the appended set of claims.

Embodiments described herein pertain to an electronic device having one or more force sensors and arrangements thereof for detecting signals indicative of intent to undock the electronic device from a dock. The electronic device may comprise an electronic display. The electronic device may include one or more batteries that provide power to one or more components of the electronic device. The electronic device may further include a first set of magnets, the first set of magnets arranged to magnetically couple with a second set of magnets of the dock. The electronic device may include a plurality of electrical contacts arranged to transfer electrical signals between the dock and the electronic device when the electronic device is magnetically docked with the dock. The dock and/or the electronic device may include force sensors for detecting a signal indicative of intent to dock and undock the electronic device from the dock. The signal may be a force or pressure distribution associated with the electronic device being lifted away from the dock or setting the electronic device onto the dock for docking.

Embodiments of such an electronic device may comprise one or more of the following features: the strain gauge may be located on a face of the dock for detecting shear force. In some embodiments, the strain gauge may be located on a bottom surface of the dock. In at least some embodiments, four strain gauges are formed on a bottom surface of the dock or on a face of the dock. The four strain gauges may form a Wheatstone full-bridge circuit such that an output voltage is indicative of a deformation of the strain gauges corresponding to the tablet computer docking and undocking from the dock. In other embodiments, the strain gauge is located on a wall of the dock. The dock may include a first plurality of magnets, wherein the first plurality of magnets is arranged to magnetically couple with a second plurality of magnets of the tablet computer.

In various embodiments, a tablet computer system comprises a dock and a tablet computer which can be removably docked from the dock. The tablet computer includes an electronic display. The tablet computer system includes one or more force sensors formed on the dock and/or the tablet computer for detection of a force or pressure distribution associated with docking and/or undocking of the tablet computer from the dock. The tablet computer system includes one or more processors configured to determine a change from a first position of the tablet computer by detecting a change in the force or pressure distribution with the one or more force sensors and determine a second position of the tablet computer based at least in part on the change. The one or more force sensors include an inertial measurement unit (IMU) sensor formed within the tablet computer for detecting a change in orientation of the tablet computer. In some embodiments, the one or more force sensors include a barometer formed within the tablet computer. In various embodiments, detecting the change in force or pressure distribution comprises comparing a measured force with a stored predefined force value. The one or more force sensors may be located on a face of the dock for detecting shear force. In some embodiments, the force sensors may be located on a face of the dock for detecting a combination of shear forces and normal forces. In some embodiments, the one or more force sensors may be located on a bottom surface of the dock. In at least some embodiments, four strain gauges are formed on a bottom surface of the dock. In other embodiments, the one or more force sensors is located on a wall of the dock. The one or more force sensors may include a strain gauge formed on the dock and/or the tablet computer. For example, four strain gauges may be formed on a bottom surface of the dock or on a face of the dock. The one or more force sensors may form a Wheatstone full-bridge circuit such that an output voltage is indicative of a deformation of the strain gauges corresponding to the tablet computer docking and undocking from the dock.

Embodiments of a method of tracking docking and undocking of a tablet computer from a dock may include determining a force or pressure distribution from one or more force sensors interfaced, directly or indirectly, with the tablet computer, determining a change from an initial position of the tablet computer by detecting a change in the force or pressure distribution detected by the one or more force sensors, and based on the determination of the change, releasing the tablet computer from the dock by modifying a state of electropermanent magnets located on the dock. The one or more force sensors is selected from the group consisting of: a strain gauge, an inertial measurement unit (IMU) sensor, and a barometer. Detecting the change in force or pressure distribution may include comparing a measured force with a stored predefined force value.

### BRIEF DESCRIPTION OF THE DRAWINGS

A further understanding of the nature and advantages of various embodiments may be realized by reference to the following figures. In the appended figures, similar components or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
**FIG. 1** illustrates an embodiment of a device that can be docked with a docking station or "dock" using magnets, according to some implementations of the present disclosure.
**FIG. 2** illustrates a rear view of an embodiment of a device that is magnetically docked with a dock, according to some implementations of the present disclosure.
**FIG. 3** illustrates a side view of an embodiment of a device that is magnetically docked with a dock, according to some implementations of the present disclosure.
**FIG. 4** illustrates forces on a device docked onto a dock, according to some implementations of the present disclosure.
**FIGS. 5A****,** **5B****,** and **5C** illustrate alternative locations of strain gauges on a dock, according to some implementations of the present disclosure.
**FIG. 6A** and **6B** illustrates exemplary measurements of strain gauges on a dock, according to some implementations of the present disclosure.
**FIGS. 7A** and **7B** illustrate touch input on a dock, according to some implementations of the present disclosure.
**FIG. 8** is a flowchart of a method, according to some implementations of the present disclosure.
**FIG. 9** illustrates a block diagram of an embodiment of a tablet dock system.

### DETAILED DESCRIPTION

Electronic devices, such as a tablet computer, may be docked to supply power, for data transfer, for audio playback, and/or be physically held, such as in an upright position. A docking mechanism for docking electronic device can include arrangements of permanent magnets. Electropermanent magnets (EPMs) include a special configuration of magnetic materials where the external magnetic field can be turned on and off by applying a current pulse. For example, an electronic device and/or a dock may include a set of permanent magnets that magnetically couple with magnets in the dock and/or electronic device, respectively.

A user may use a physical button, a touchscreen button, or a voice command to signal an intent to dock or undock an electronic device. These approaches can have various drawbacks such as, limited applicability and interference with the aesthetic of the electronic device. There is a need in the art for a user-friendly indication of intent to dock and/or undock electronic devices from a dock.

According to various embodiments described herein, a user may signal an intent to dock or undock an electronic device from a dock which may, in turn, activate or deactivate EPMs implemented into the electronic device and/or the dock. Alternatively, the user may also signal an intent to dock or undock an electronic device from a dock where neither the electronic device nor the dock implements EPMs, in other embodiments.

The embodiments detailed herein are focused an electronic device having one or more force sensors, such as strain gauges, for detecting an intent to undock the electronic device from a dock. In some embodiments, the electronic device is a tablet computer that is a component of a tablet computer system. Specifically, a tablet computer can serve as a home assistant device and/or hub to manage smart home devices in an environment. The tablet computer may be able to charge and output audio via the dock, record video, communicate with a remote server system, and interact with users via spoken communications. For example, a home assistant device may provide automated control or voice control of devices, appliances, and systems, such as heating, ventilation, and air conditioning ("HVAC") system, lighting systems, home theater, entertainment systems, as well as security systems. Smart home networks may include control panels that a person may use to input settings, preferences, and scheduling information that the smart home network uses to provide automated control of the various devices, appliances, and systems in the home. For example, the person may input a schedule indicating when the person is away from the home, and the smart home network uses this information along with information obtained from various devices in the home to detect unauthorized entry when the user is away. The tablet computer may be left docked with a dock to charge its battery and use other features of the dock, such as an integrated speaker. The tablet computer may be removed from the dock for convenience to be used or displayed at another location. When not in use (whether docked, not docked, or both), photos or photo albums selected by a user may be presented by the tablet.

Many other types of electronic devices may benefit from the various force sensor implementations described herein. For example, smartphones, gaming devices, e-readers, personal digital assistants (PDAs), digital paper tablets, and smart picture frames that can be removably attached with a base or another device may benefit from various embodiments of the various force sensors as detailed herein. Furthermore, the electronic device may be an assistant device (e.g., Google^{®} Nest^{®} Hub; Google^{®} Nest^{®} Hub Max); a home automation controller (e.g., controller for an alarm system, thermostat, lighting system, door lock, motorized doors, etc.); a gaming device (e.g., a gaming system, gaming controller, data glove, etc.); a communication device (e.g., a smart phone such as a Google^{®} Pixel^{®} Phone, cellular phone, mobile phone, wireless phone, portable phone, radio telephone, etc.); and/or other computing device (e.g., a tablet computer, phablet computer, notebook computer, laptop computer, etc.).

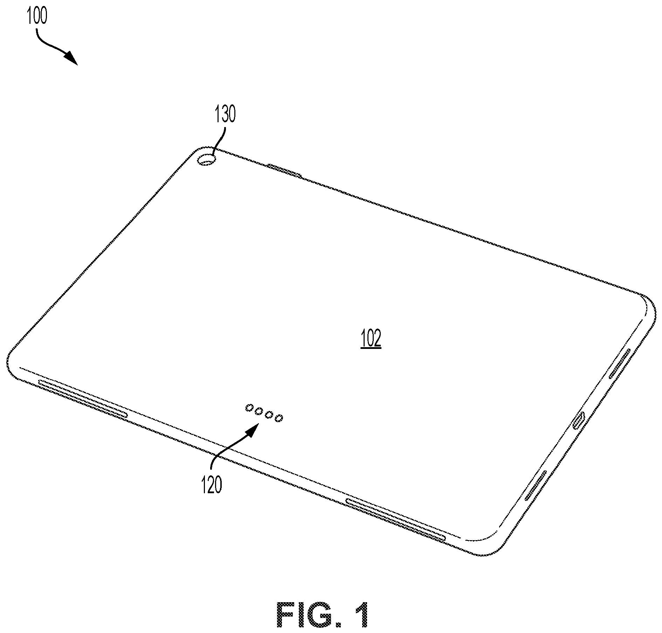

Further detail is provided in reference to the figures. FIG. 1 illustrates an embodiment of an electronic device 100 that is configured to dock with a dock using magnets and, in some embodiments, contact pads. The electronic device 100 can be a tablet computer or, more specifically, a tablet computer that serves as a home assistant device or hub as previously detailed. One or more magnets may be hidden within the electronic device 100 behind rear surface 102. Device 100 includes multiple conductive contact pads 120 (e.g., metallic pads) that are used to transfer data with and/or obtain power from a dock when the device 100 is in a docked position. As illustrated, four contact pads 120 are present. In other embodiments, a greater or fewer number of contact pads 120 may be present. The arrangement of contact pads 120 can also vary by embodiment. In other embodiments, rather than using contact pads, some other form of electrical contact may be used, such as pins or a combination of pads and pins. Other components, such as camera 130, may be present on or accessible through rear surface 102.

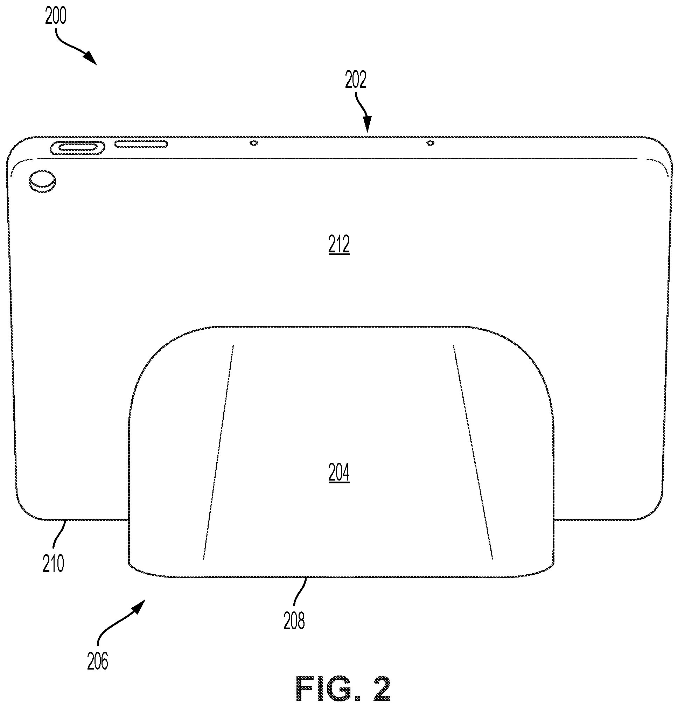

**FIG. 2** illustrates a rear view of an embodiment of a system 200 that includes an electronic device 202 docked with a dock 204. The dock 204 connects with the electronic device 202 via one or more magnets of dock 204 that magnetically connect corresponding magnets of the electronic device 202. When coupled, the electronic device 202 can be suspended off of surface 206, upon which a base 208 of the dock 204 rests. Accordingly, edge 210 may not touch surface 206 when the electronic device 202 is docked with the dock 204.

The dock 204 magnetically couples with the electronic device 202 within the region of rear surface 212. Since the connection is magnetic, a user may pull the electronic device 202 away from the dock 204 to remove. To mate, the user may move the electronic device 202 close to the dock 204. Once close, the magnets of the electronic device 202 and magnets of the dock 204 help guide the electronic device 202 into the proper alignment on the dock 204. When docked, contact pads (such as contact pads 120 in FIG. 1) contact corresponding pins (or another form of electrical contact) present on the mating surface of the dock 204.

In some embodiments, one or more electropermanent magnets may be present within the dock 204 that can be engaged or disengaged. When engaged, such magnets may prevent the electronic device 202 from being easily removed by a user from the dock 204. When disengaged, it may be relatively easy (compared to when engaged) for the user to the electronic device 202 from the dock 204.

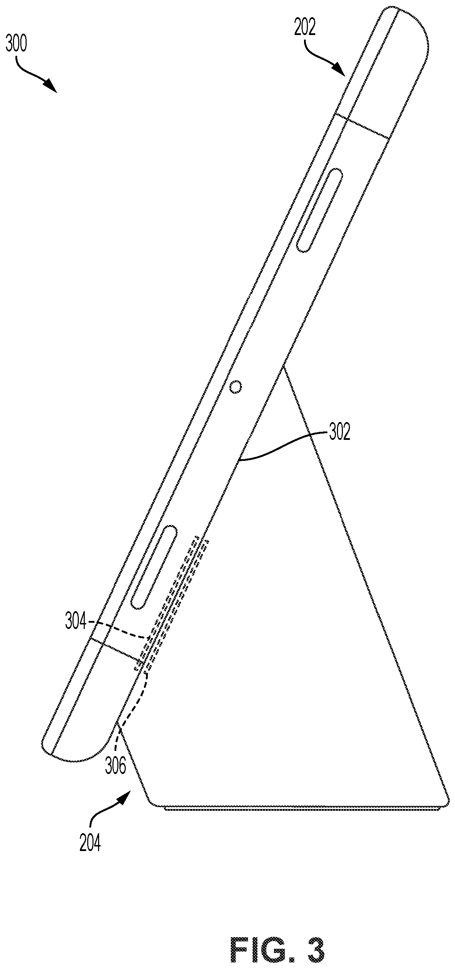

**FIG. 3** illustrates a side view of a system 300 that includes an embodiment of an electronic device. As can be seen from the side view, the electronic device 202 is docked with dock 204. Mating surface 302 indicates where the rear surface 212 of the electronic device 202 contacts the dock 204.

Within region 304, a first plurality of magnets is present within the electronic device 202. In corresponding locations within region 306, a second plurality of magnets is present within the dock 204. The magnets are arranged such that, when brought into proximity, the magnets of the electronic device 202 attract to the magnets of the dock 204 to help correctly position and align the dock 204 against the electronic device 202 and hold the electronic device 202 in a correct position on the dock 204. In other aspects, regions 304 and 306 may extend further upward on the dock 204 and/or extend the length of the dock 204 which contacts the electronic device 202. For example, regions 304 and 306 may be any size and located at any location on the electronic device 202 and/or the dock 204.

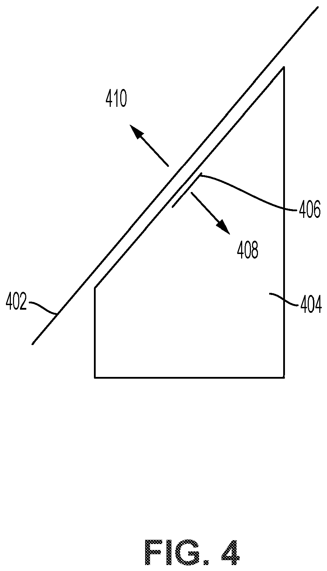

Referring now to **FIG. 4****,** various forces on an electronic device 402 and a dock 404 are illustrated. A force sensor 406, according to various embodiments described throughout the present disclosure, is integrated with and located within a face of the dock 404. For example, the force sensor 406 may be placed internally on or near the face of the dock 404. When an electronic device 402 is not docked, the force sensor 406 detects a signal indicative of an unloaded reading. In contrast, when an electronic device 402 is docked, the force sensor 406 detects a signal indicative of a loaded reading. For example, when the electronic device 402 is docked, a deformation of the face of the dock 404 is measured equal to the combination of the weight of the electronic device 402 and the attractive force of any magnets implemented in the electronic device 402 and/or the dock 404. If the screen is tapped, the deformation of the face of the dock 404 may be substantially in the same direction as the weight of the docked electronic device 402. During undocking, lifting the electronic device 402 causes the deformation of the face of the dock 404 to be in the opposite direction (e.g., the electronic device 402 is being removed from the dock 404 and the weight of the of the dock 404 is being pulled down due to gravity). The difference is measured and used to trigger an undocking event, in at least some embodiments. Force sensors according to various embodiments described herein, are configured to detect a signal which is indicative of intent to dock and/or undock an electronic device from a dock. In various embodiments, force sensors, such as strain gauges, are configured to perform measurements indicative of undocking of the tablet computer from the dock and docking of the tablet computer with the dock. In various embodiments, the force sensors are configured to detect signals which are indicative of docking/undocking and are differentiated from other interactions with the electronic device/dock such as screen taps, presses, swipes, button presses, dock rotations, etc. Implementing force sensors for detecting changes in forces indicative of docking and undocking advantageously results in a better user experience, with a more natural "grab and go" signal to undock.

In various embodiments, a force sensor is a strain gauge. Strain gauges have a variable resistance depending on the force applied. These changes may be read with an analog-to-digital converter (ADC) when an excitation voltage is applied and a strain gauge is used in a resistor divider, in at least some embodiments. In some embodiments, a Wheatstone bridge configuration comprising four strain gauges and amplifier may be used for relatively more accurate measurements of signals detected by the strain gauges. In one embodiment, four strain gauges form a Wheatstone full-bridge circuit such that an output voltage is indicative of a deformation of the strain gauges corresponding to the electronic device docking and undocking from the dock. In some embodiments, a Wheatstone quarter-bridge or a Wheatstone half-bridge may be formed by strain gauges. Strain gauges are low cost, low power, and relatively small. Accordingly, in some embodiments, a plurality of strain gauges may be used. For example, a plurality of strain gauges may be used for temperature compensation, to increase sensitivity of the structure, to measure a different part of the structure, etc. Multiple strain gauges may be used to act as a load cell, as would be appreciated by one having ordinary skill in the art.

In other aspects, the force sensor may also be a gyroscope, an accelerometer, a barometer (e.g., for detecting squeezing or changes in air pressure within an electronic device when the electronic device is grasped and lifted), a weight sensor, etc. An electronic device and/or a dock as described throughout the present disclosure may include any combination of the foregoing force sensors. For example, a dock may include a strain gauge and an electronic device may include a barometer. In another example, a dock may include both a strain gauge and an accelerometer.

In various embodiments, force sensors may be associated with thresholds for determining whether a signal is indicative of docking or undocking. Hardcoded thresholds may be used to determine undocking intent. In other aspects, a machine learning model may be trained on user interaction data to determine if there is undocking intent based on signals received from the force sensors. Thresholds and/or thresholds determined by a machine learning model may be used to determine if there is a docking/undocking event and an electronic device/dock system adjusts the state of the electronic device and/or the dock accordingly.

In at least some implementations, a force sensor is one component of signaling and detecting undocking intent. For example, force sensor data may be used in combination with data and/or signals gathered from one or more of a camera, a microphone, a presence, a touch, a button, etc.

The force sensor 406 is configured to detect a change in force indicative of docking and undocking the electronic device 402 from the dock 404. For example, the force sensor 406 is configured to detect a change in a force 408 directed into the face of the dock 404 and/or a change in a force 410 directed out of the face of the dock 404. In particular, lifting the electronic device 402 from the dock 404 (e.g., undocking) results in a force 410 detected by the force sensor 406 and directed out of the face of the dock 404. In contrast, force 408 may be detected by the force sensor 406 and directed into the face of the dock 404.

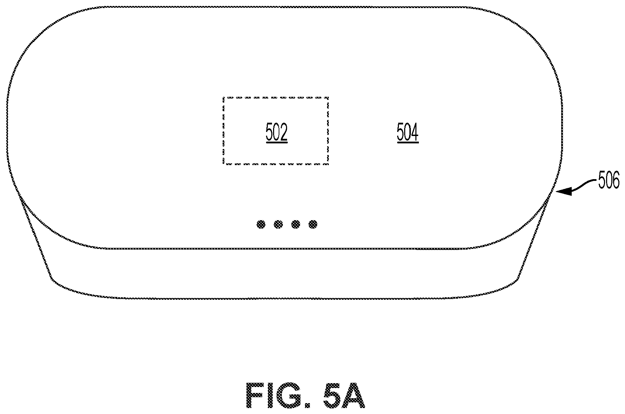

**FIG. 5A-5C** illustrate embodiments of force sensors 502 implemented in an electronic device. FIG. 5A illustrates a front top view of the implementation shown in FIG. 4 having the force sensor 502 located on a face 504 of a dock 506. In some aspects, the force sensor 502 is positioned to measure force applied at or near the center of the face 504. Although one force sensor 502 is shown, in other embodiments at least two force sensors 502, at least three force sensors 502, at least four force sensors 502, etc., may be implemented into the face 504 of the dock 506. For example, in one aspect, four force sensors 502 are implemented into the face 504 of the dock 506 and are arranged at relative right angles (90°) to each other.

In other aspects, one or more of the force sensors 502 located on the face 504 of the dock 506 may be used to detect signals indicative of shear force resulting from undocking the electronic device from the face 504 of the dock 506. One of the force sensors 502 may be used to detect signals indicative of shear force in combination with one or more force sensors 502 which detect signals indicative of a changes in other forces or pressure distribution.

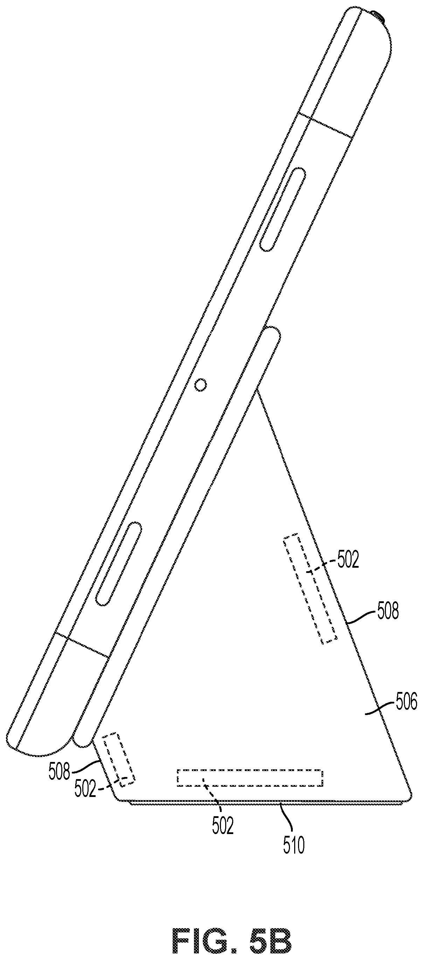

FIG. 5B includes a plurality of force sensors 502 implemented in other locations in a dock 506. Force sensors 502 may located within the vertical walls 508 of the dock 506, or substantially vertical walls, of the dock 506. For example, one force sensor 502 may be implemented in each vertical wall 508 of the dock 506. In other embodiments, any number of force sensors 502 may be implemented into any wall 508 of the dock 506. As further shown in FIG. 5B, a force sensor 502 may be implemented horizontally into a bottom surface 510 of the dock 506. In various approaches, a plurality of force sensors 502 may be implemented into a bottom surface 510 of the dock 506. The any number of force sensors 502 may be implemented into any combination of walls 508, a face 504, a bottom surface 510, etc., of a dock 506. For example, as shown, force sensors 502 may be implemented into vertical walls 508 and a bottom surface 510 of the dock 506. In alternative embodiments, force sensors 502 may only be located in vertical walls 508 or the bottom surface 510 or the face 504 of the dock 506.

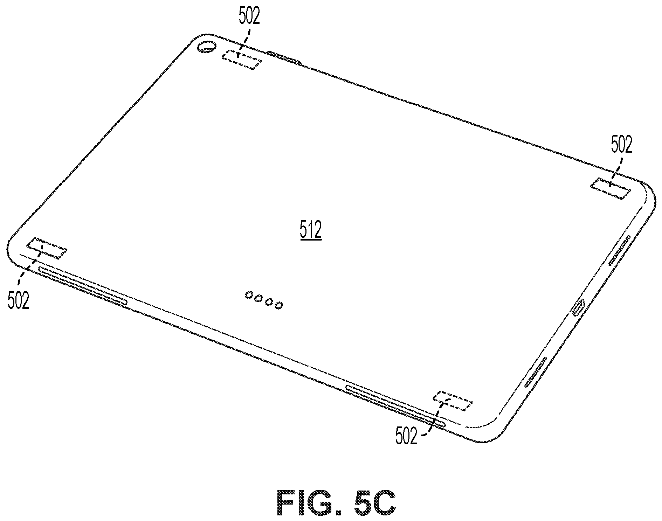

As shown in FIG. 5C, an alternative embodiment having force sensors 502 implemented into an electronic device 512 is illustrated. As shown, four force sensors 502 are implemented into the electronic device 512, one force sensor 502 located at each corner of the electronic device 512, although any arrangement and number of force sensors 502 is contemplated. The force sensors 502 in this implementation may be particularly used to detect tilting of the electronic device 512 and differentiating signals indicative of undocking from signals indicative of other interactions with the electronic device 512.

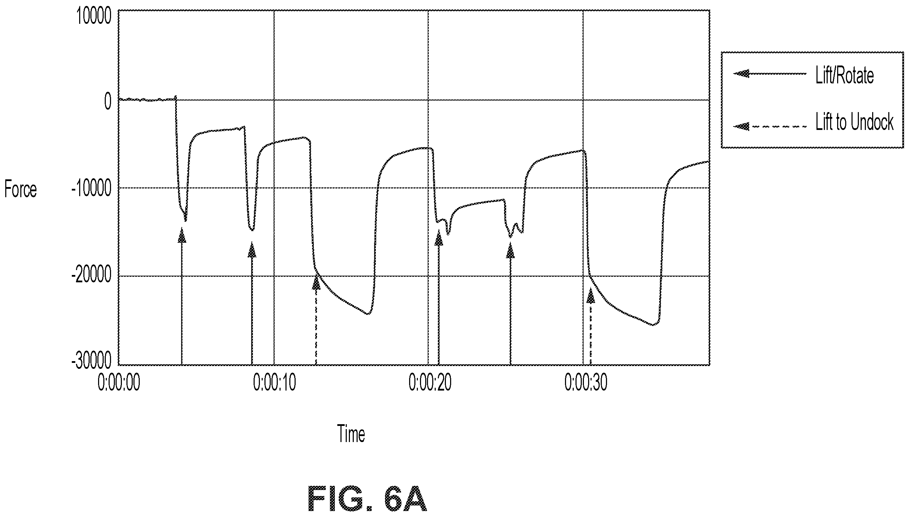

Referring now to **FIGS. 6A-6B****,** each graph illustrates forces detected by one force sensor located on a bottom surface of a dock and 3 force sensors located on the face of the dock, respectively. In some embodiments, a force sensor is an inertial measurement unit (IMU). IMUs may comprise a gyroscope and an accelerometer. IMUs are similarly low cost, low power, and relatively small devices. The gyroscope component provides orientation information indicative of docking/undocking. The accelerometer component provides linear acceleration indicative of docking/undocking. Such sensor data gathered from an IMU may be different from sensor data which would be gathered for touching, moving, or other interactions with the electronic device and/or the dock. For example, when the electronic device is docked and a user is interacting with the electronic device (e.g., touching, tapping, swiping, but not undocking), the accelerometer measurements are mostly in the Z direction and the gyroscope measurements are mostly in the Y direction (e.g., roll). In another example, when the electronic device is being rotated so that a user can see it from a different angle, the gyroscope measurements are mostly in the X and Y directions (e.g., pitch and yaw). In yet another example, when the electronic device is being undocked, the accelerometer measurements are mostly in the Z direction and the gyroscope measurements are mostly in the Y direction (e.g., roll).

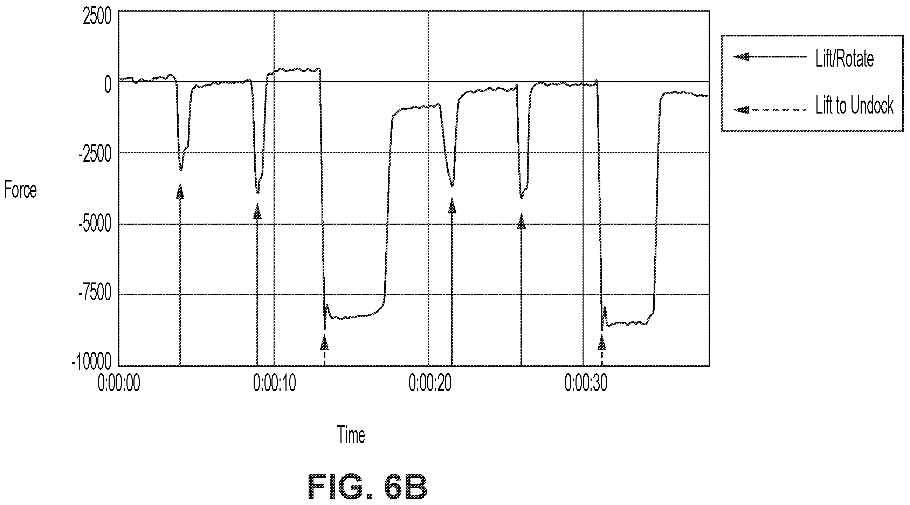

As shown in FIG. 6A, a force sensor located on the bottom of the dock detects changes in force associated with lifting/rotating an electronic device and lifting an electronic device to undock. Undocking changes in force are relatively more gradual compared to other interactions. Similarly, as shown in FIG. 6B, 3 force sensors located on the face of the dock detect changes in force associated with lifting/rotating an electronic device and lifting an electronic device to undock. Undocking changes in force are relatively sharper and then stabilize gradually compared to other interactions.

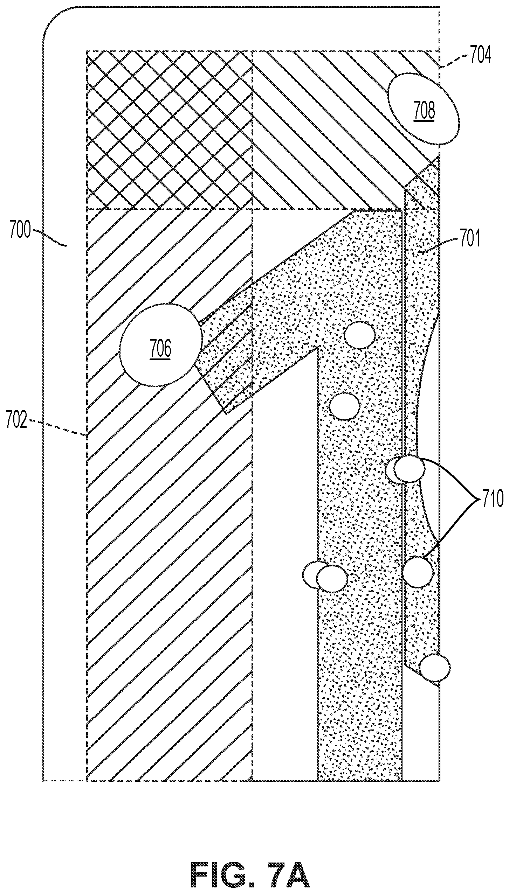

**FIGS. 7A-7B** illustrate exemplary aspects of touch characteristics of a user touching an electronic display (e.g., touch screen display) of an electronic device 700, such as a tablet computer as described in detail throughout the present disclosure. In particular, the electronic device 700 may be a tablet computer that is part of a home assistant device system. In other embodiments, a force sensor detects touch characteristics that are indicative of undocking and docking. For example, to provide a more intuitive and improved undocking experience, force sensors may be used to interpret touch input indicative of undocking intent. When a touch event occurs, the x/y position and/or the major/minor axes and rotation angle may be used to determine whether an electronic device is being undocked from a dock. For example, when a user grabs an electronic device with the intent to undock the electronic device, the user's thumb is typically used around the left/top/right of the screen. Accordingly, bounds on the x/y may be used, as described in further detail below with respect to FIGS. 7A-7B.

In another example, the thumb leaves a larger touch area than when an index finger is used to interact with the electronic device. A detected touch surface area may be used to signal intent to undock the electronic device. In yet another example, a rotation angle may be associated with a large touch surface area (e.g., from using the thumb compared to using an index finger) and indicative of a grasping motion around the electronic device and undocking the electronic device. In other aspects, multi-touch characteristics may be used to indicate intent to undock the electronic device from the dock. For example, one embodiment may require touch areas on both the left side and the right side of the electronic device. In yet another aspect, invisible touch areas or discrete buttons may be used. In another aspect, touch areas may only be shown and/or active during certain events such as a new presence detection or predetermined swiping motions.

Each of FIGS. 7A-7B illustrate a top left corner of a front view of an electronic device 700 having textual information 701 displayed. Bounds x 702 and bound y 704 outline edge portions of a front view of an electronic display of the electronic device 700. In various aspects, bounds x 702 may extend the entire left and right sides of the electronic display (e.g., from a topmost end to a bottommost end). Similarly, bounds y 704 may extend across the topmost and bottommost sides of the electronic display.

FIG. 7A illustrates an exemplary aspect of touch characteristics which are indicative of undocking an electronic device. A user grabs the electronic device with the intent to undock. The thumb is often used around the left and/or right top section of the screen. Bounds x 702 and bound y 704 may be used to detect touch events 706 and 708 which may be indicative of undocking. Touch events 706 and 708 are distinguishable from other touches 710 which are indicative of other interactions with the electronic device (e.g., taps) which are relatively smaller and toward a middle portion of a display of the electronic device.

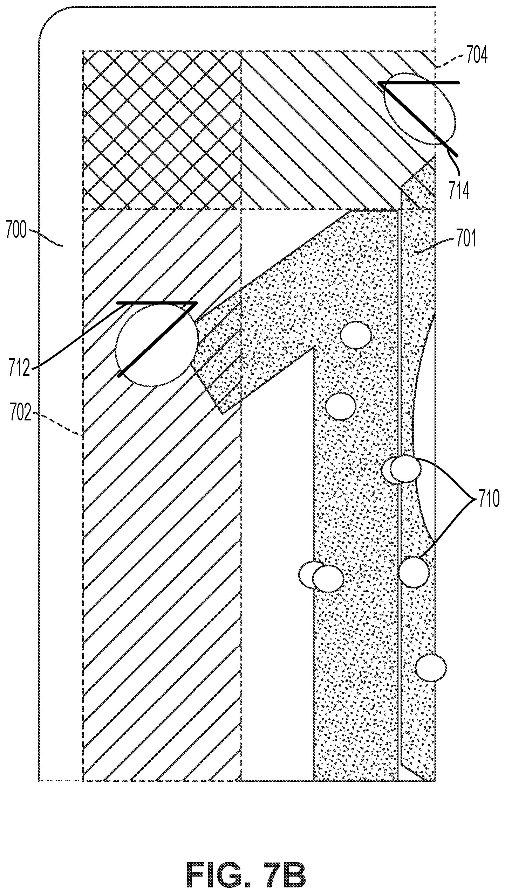

FIG. 7B illustrates an exemplary aspect of touch characteristics which are indicative of undocking an electronic device. A user grabs the electronic device with the intent to undock. The thumb is often used around the left and/or right top section of the screen. There is often a rotation angle associated these touches where there is a grasping motion around the electronic device. Bounds x 702 and bound y 704 may be used to detect angled touch events 712 and 714 which may be indicative of undocking. Touch events 712 and 714 are distinguishable from other touches 710 which are indicative of other interactions with the electronic device (e.g., taps) which are relatively smaller and toward a middle portion of a display of the electronic device.

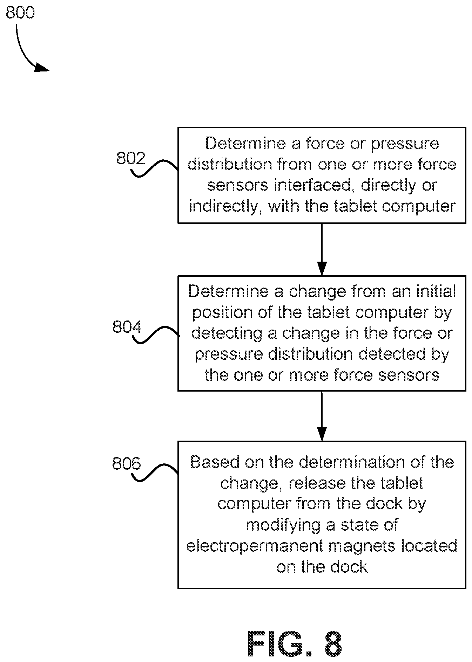

**FIG. 8** includes a flowchart of a method 800 for tracking docking and undocking of a tablet computer from a dock. Step 802 of method 800 includes determining a force or pressure distribution from one or more force sensors interfaced, directly or indirectly, with the tablet computer. The one or more force sensors detects signals indicative of an initial position of the tablet computer relative to the dock. For example, the signals may be indicative that the tablet computer is docked or undocked. The one or more force sensors may be any type of force sensor described in detail above. For example, the one or more force sensors may include a strain gauge, an inertial measurement unit (IMU) sensor, a barometer, etc., or any combination thereof. The force sensors may be integrated into the dock such that the force sensors interface, directly or indirectly, with the tablet computer. In various aspects, the one or more force sensors may be located on, located within, integrated into, etc., in the dock. In at least some approaches, at least one of the one or more force sensors is located in the tablet computer itself.

Step 804 includes determining a change from an initial position of the tablet computer by detecting a change in the force or pressure distribution detected by the one or more force sensors. For example, the one or more sensors detect signals indicative that the initial position of the tablet computer is docked. A processor in the tablet computer and dock system determines that the initial position is docked where the one or more force sensors detect a weight, a pressure, a force, etc., on the force sensors associated with the tablet computer's weight resting on the dock, in one aspect. A change in the initial position may be determined by a change in the force or pressure distribution detected by the one or more sensors, for example, when the tablet computer is lifted off of the dock and stops applying pressure to the dock.

In at least some aspects, a change in position is determined by the change in force or pressure distribution exceeding a predefined threshold. For example, detecting the change in force or pressure distribution comprises comparing a measured force with a stored predefined force value. A predefined threshold may be a hardcoded threshold determined and set by a manufacturer, a supplier, a user, etc. In other aspects, the predefined threshold is generated by a machine learning model. For example, docking and undocking sensor data may be collected from a plurality of users. Machine learning models known in the art may be used to determine whether a change in force or pressure distribution is indicative of a change in position and differentiate the change from changes which result from other interactions with the tablet computer or dock. In various aspects, the predefined threshold includes a time constraint. For example, if the force associated with the weight of the tablet computer on the dock is below a threshold for a given time (e.g., 50 to 100 ms), a change in position is determined by the system comprising the tablet computer and the dock.

Step 806 includes, based on determination, release the tablet computer from the dock by modifying a state of electropermanent magnets located on the dock. In various embodiments, the dock in a tablet dock system includes electropermanent magnets which can be engaged or disengaged. In particular, based on received measurements from the force sensors, the status of the electropermanent magnets may be modified from engaged or disengaged. When engaged, such magnets may prevent the tablet computer from being easily removed by a user from the dock. When disengaged, it may be relatively easy (compared to when engaged) for the user to the tablet computer from the dock. The electropermanent magnets may be engaged and/or disengaged in response to a change in position of the tablet computer (e.g., a change in the force or pressure distribution detected by the one or more force sensors).

In some aspects, step 806 may include determining an updated position of the tablet computer. In various aspects, a new stable level of a force or pressure distribution (e.g., low variance) may be indicative of a new position. The machine learning model discussed above is capable of filtering out noise and/or results indicative of taps or swipes (e.g., not undocking or docking). In other aspects, the processor of the system comprising the tablet computer and the dock is able to determine the new position when the signals detected by the one or more force sensors become stable after a change.

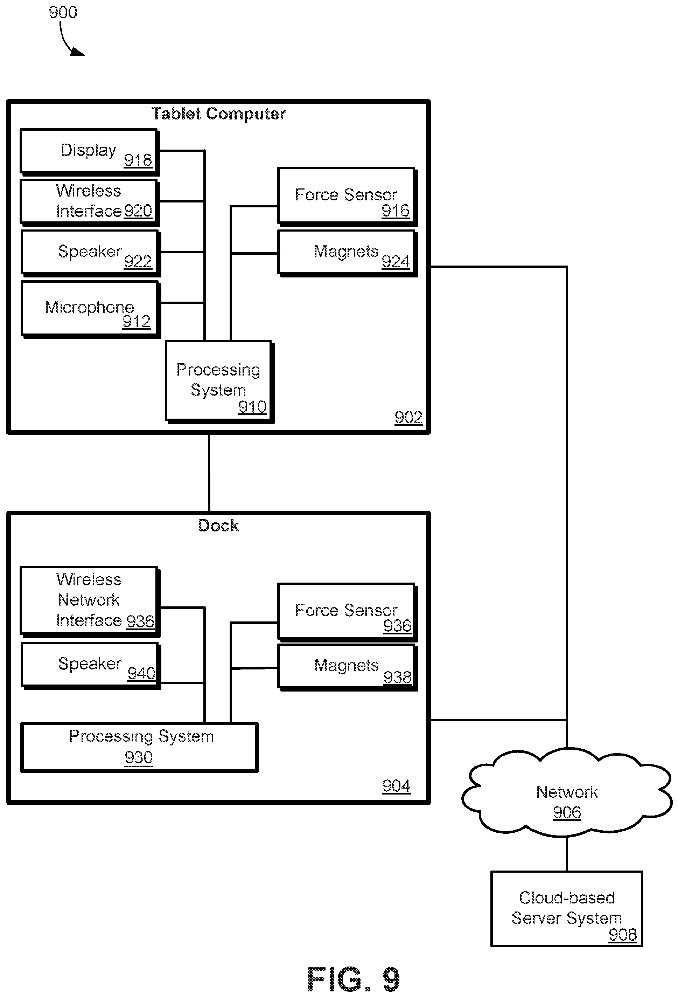

**FIG. 9** illustrates an embodiment of a tablet dock system 900. System 900 can include tablet computer 902, a dock 904, a network 906; and cloud-based server system 908. The tablet computer 902 can include: processing system 910; one or more microphones 912; a force sensor 916; an electronic display 918; and a wireless interface 920. Processing system 910 may include one or more processors, which can include special-purpose or general-purpose processors that execute instructions stored using one or more non-transitory processor readable mediums. Processing system 910 can include one or more processors that are designed to execute machine learning (ML) models. Such processors, while able to analyze whether speech is or is not present, may not be able to analyze the content of such speech. Therefore, privacy of the content of the speech is maintained. Syntiant^{®} Neural Decision Processors^{™} represent one family of commercial processors that can execute a machine learning model that is trained to determine the presence of speech but otherwise ignore the content of such speech.

Microphones 912 are configured to receive audio input from a user of the tablet computer 902. One or more microphones 912 may be in communication with processing system 910. If multiple microphones 912 are present, based upon the difference in time of arrival of sound at the multiple microphones, a direction from which a sound, such as speech, originated may be determined in relation to a SIM device. One or more microphones 912 may be in direct communication with only processing system 910 via a direct connection. Specifically, one or more microphones 912 can be electrically connected to only a processor that executes a machine learning model that determines (e.g., a binary determination of whether or not speech is determined to be present) or scores (e.g., indicates a likelihood of speech being present) if speech is or is not present. The processor does not have the capability to analyze the content of the speech. In various embodiments, the tablet computer 902 may include a speaker 922 of a type known in the art to output audio feedback to commands.

Force sensor 916 is in communication with processing system 910. One or more force sensor 916 may include an IMU, an accelerometer, a gyroscope, a barometer, etc., or any combination thereof. Force sensors 916 are used to detect signals indicative of intent to undock and/or dock the tablet computer 902 from the dock 904. In some aspects, force sensor 916 can be used to determine the orientation of the tablet computer 902 to the ground based on the acceleration of gravity and can be used to determine movement of the tablet computer 902. In other aspects, the tablet computer 902 may comprise any force sensor described herein.

Magnets 924 may include one or more magnets arranged to magnetically couple with corresponding one or more magnets 938 of the dock. Magnets 924 and magnets 938 may be used to align the tablet computer 902 with the dock 904 during docking. Magnets 924 (or magnets 938) may include EPMs or permanent magnets, or a combination thereof.

Wireless interface 920 is in communication with processing system 910 and allows for communication with various wireless networks and/or wireless devices using one or more communication protocols. Wireless interface 920 may allow for communication with a Wi-Fi based wireless local area network. Wireless interface 920 can allow for communication directly with other devices, such as via Bluetooth, Bluetooth Low Energy (BLE), or some other low-power device-to-device communication protocol. In some embodiments, wireless interface 920 allows for communication with a wearer's smartphone, thus allowing information collected using the tablet computer 902 to be analyzed by and presented using the wearer's smartphone.

In some embodiments, electronic display 918 may be present. In various aspects, the electronic display 918 may display any visual information associated with any applications running on the tablet computer 902 known in the art. Electronic display 918 can allow for information determined based on data collected from the various sensors of the tablet computer 902 to be directly presented to a user. For example, the electronic display 918 may display information or commands associated with smart home devices, social media applications, internet searches, weather applications, news applications, etc. For instance, electronic display 918 may be able to present text and/or graphical indications of whether the wearer's social interactions are above, at, or below a goal for a specific time period, such as a day.

The tablet computer 902 may be or may be used with a smartphone, a smartwatch, laptop, gaming device, or a smart home hub device that is used to interact with various smart home devices present within a home. The dock 904 may generally be part of a smart home assistant device system. Generally, the dock 904 can include a housing (e.g., a dock housing) that houses all of the components of the dock 904.

The dock 904 can include a processing system 930. Processing system 930 can include one or more processors configured to perform various functions. Processing system 930 can include one or more special-purpose or general-purpose processors. Such special-purpose processors may include processors that are specifically designed to perform the functions detailed herein. Such special-purpose processors may be ASICs or FPGAs which are general-purpose components that are physically and electrically configured to perform the functions detailed herein. Such general-purpose processors may execute special-purpose software that is stored using one or more non-transitory processor-readable mediums, such as random access memory (RAM), flash memory, a hard disk drive (HDD), or a solid state drive (SSD).

Dock 904 may include a force sensor 936 such as the force sensor 916 located on the tablet computer 902 and described throughout the present disclosure. The dock 904 may include a speaker 940 (similar to speaker 922) of a type known in the art to output audio feedback to commands.

In various embodiments, other sensors or components (not shown) may be located on the dock 904. For example, one or more environmental sensors may be incorporated into the dock 904 and can include a light sensor, a microphone for receiving audio input from a user, a temperature sensor, etc. In some embodiments, multiple instances of some or all of these sensors may be present. A camera and/or humidity sensor may be incorporated into the dock 904 and/or the tablet computer 902. As another example, active infrared sensors may be included. In some embodiments, some data, such as humidity data, may be obtained from a nearby weather station that has data available via the Internet. In some embodiments, active acoustic sensing methods, including, but not limited to, sonar and ultrasound, and including either single or arrayed acoustic sources and/or receivers may be implemented. Such arrangements may be used as one or more adjunct sensing modalities incorporated with the other sensors and methods described herein.

Tablet computer 902 may include various interfaces. Display 918, which may be a touchscreen, can allow processing system 910 to present information for viewing by one or more users. A wireless network interface can allow for communication using a wireless local area network (WLAN), such as a WiFi-based network. Speaker 922 can allow for sound, such as synthesized speech, to be output. For instance, responses to spoken commands received via microphone 912 may be output via speaker 922 and/or display 918. The spoken commands may be analyzed locally by the tablet computer 902 or may be transmitted via a wireless network interface to cloud-based server system 908 for analysis. A response, based on the analysis of the spoken command, can be sent back to the tablet computer via the wireless network interface for output via speaker 922 and/or display 918. Additionally, or alternatively, the speaker 922 and microphone 912 may be collectively configured for active acoustic sensing, including ultrasonic acoustic sensing. Additionally, or alternatively, other forms of wireless communication may be possible, such as using a low-power wireless mesh network radio and protocol (e.g., Thread) to communicate with various smart home devices. In some embodiments, a wired network interface, such as an Ethernet connection, may be used for communication with a network. Further, the evolution of wireless communication to fifth generation (5G) and sixth generation (6G) standards and technologies provides greater throughput with lower latency which enhances mobile broadband services. 5G and 6G technologies also provide new classes of services, over control and data channels, for vehicular networking (V2X), fixed wireless broadband, and the Internet of Things (IoT). Such standards and technologies may be used for communication by the tablet computer 902.

The low-power wireless mesh network radio and protocol may be used for communicating with power limited devices. A power-limited device may be an exclusively battery powered device. Such devices may rely exclusively on one or more batteries for power and therefore, the amount of power used for communications may be kept low in order to decrease the frequency at which the one or more batteries need to be replaced. In some embodiments, a power-limited device may have the ability to communicate via a relatively high power network (e.g., WiFi) and the low-power mesh network. The power-limited device may infrequently use the relatively high power network to conserve power. Examples of such power-limited devices include environmental sensors (e.g., temperature sensors, carbon monoxide sensors, smoke sensors, motion sensors, presence detectors) and other forms of remote sensors.

Notably, some embodiments of the tablet computer 902 do not have any still camera or video camera. By not incorporating an on-board camera, users nearby may be reassured about their privacy. For example, the tablet computer 902 can typically be installed in a user's bedroom. For many reasons, a user would not want a camera located in such a private space or aimed toward the user while the user is sleeping. In other embodiments, the tablet computer 902 may have a camera, but the camera's lens may be obscured by a mechanical lens shutter. In order to use the camera, the user may be required to physically open the shutter to allow the camera to have a view of the environment of the tablet computer 902. The user can be assured of privacy from the camera when the shutter is closed.

Wireless network interface can allow for wireless communication with network 906. Network 906 can include one or more public and/or private networks. Network 906 can include a local wired or wireless network that is private, such as a home wireless LAN. Network 906 may also include a public network, such as the Internet. Network 906 can allow for the tablet computer 902 to communicate with remotely located cloud-based server system 908.

Cloud-based server system 908 may additionally or alternatively provide other cloud-based services. For instance, the tablet computer 902 may additionally function as a home assistant device. A home assistant device may respond to vocal queries from a user. In response to detecting a vocal trigger phrase being spoken, the tablet computer 902 may record audio. A stream of the audio may be transmitted to cloud-based server system 908 for analysis. Cloud-based server system 908 may perform a speech recognition process, use a natural language processing engine to understand the query from the user, and provide a response to be output by the tablet computer 902 as synthesized speech, an output to be presented on display 918, and/or a command to be executed by the tablet computer 902 (e.g., raise the volume of the tablet computer 902) or sent to some other smart home device. Further, queries or commands may be submitted to cloud-based server system 908 via display 918, which may be a touchscreen. For instance, the tablet computer 902 may be used to control various smart home devices or home automation devices. Such commands may be sent directly by the tablet computer 902 to the device to be controlled or may be sent via cloud-based server system 908.

It should be noted that the methods, systems, and devices discussed above are intended merely to be examples. It must be stressed that various embodiments may omit, substitute, or add various procedures or components as appropriate. For instance, it should be appreciated that, in alternative embodiments, the methods may be performed in an order different from that described, and that various steps may be added, omitted, or combined. Also, features described with respect to certain embodiments may be combined in various other embodiments. Different aspects and elements of the embodiments may be combined in a similar manner. Also, it should be emphasized that technology evolves and, thus, many of the elements are examples and should not be interpreted to limit the scope of the invention.

Specific details are given in the description to provide a thorough understanding of the embodiments. However, it will be understood by one of ordinary skill in the art that the embodiments may be practiced without these specific details. For example, well-known, processes, structures, and techniques have been shown without unnecessary detail in order to avoid obscuring the embodiments. This description provides example embodiments only, and is not intended to limit the scope, applicability, or configuration of the invention. Rather, the preceding description of the embodiments will provide those skilled in the art with an enabling description for implementing embodiments of the invention. Various changes may be made in the function and arrangement of elements without departing from the scope of the invention.

Also, it is noted that the embodiments may be described as a process which is depicted as a flow diagram or block diagram. Although each may describe the operations as a sequential process, many of the operations can be performed in parallel or concurrently. In addition, the order of the operations may be rearranged. A process may have additional steps not included in the figure.

## Claims

1. A tablet dock system (200, 300, 900) comprising:
a dock (204, 404, 506, 904), the dock comprising:
a dock housing;
a mating surface (204, 302, 504) formed by the dock housing configured to allow a tablet computer (100, 202, 402, 512, 700, 902) to be removably docked with the tablet dock system (200, 300, 900); and
a force sensor (406, 502, 916) comprising a strain gauge attached with the dock housing, the strain gauge being configured to perform measurements indicative of undocking of the tablet computer (100, 202, 402, 512, 700, 902) from the dock (204, 404, 506, 904) and docking of the tablet computer (100, 202, 402, 512, 700, 902) with the dock (204, 404, 506, 904);
one or more processors that determines whether the tablet is docking or undocking based on one or more received measurements from the strain gauge;
one or more electropermanent magnets located on the dock (204, 404, 506, 904), wherein the system releases the tablet computer (100, 202, 402, 512, 700, 902) from the dock (204, 404, 506, 904) by modifying a state of the one or more electropermanent magnets based on the one or more received measurements from the strain gauge.

2. The system (200, 300, 900) according to claim 1, wherein the force sensor (406, 502, 916) is configured for measuring a deformation of the dock (204, 404, 506, 904) equal to a combination of a weight of an electronic device and an attractive force of the electropermanent magnets of the dock (204, 404, 506, 904) and/or magnets of the electronic device when the electronic device is docked, and a deformation of the dock (204, 404, 506, 904) in an opposite direction during undocking of the electronic device.

3. The system (200, 300, 900) according to claim 2, wherein the system is configured for triggering an undocking event upon measuring a difference between the deformation when the electronic device is docked and during undocking of the electronic device.

4. The system (200, 300, 900) of any of claims 1-3, wherein the strain gauge is located on the mating surface (204, 302, 504) of the dock (204, 404, 506, 904) for detecting shear force, or
wherein the strain gauge is located on a bottom surface (510) of the dock (204, 404, 506, 904).

5. The system (200, 300, 900) of any of claims 1-4, comprising four strain gauges formed on a bottom surface (510) of the dock or on a mating surface (204, 302, 504) of the dock.

6. The system of claim 5, wherein the four strain gauges form a Wheatstone full-bridge circuit such that an output voltage is indicative of a deformation of the strain gauges corresponding to the tablet computer (100, 202, 402, 512, 700, 902) docking and undocking from the dock (204, 404, 506, 904).

7. The system (200, 300, 900) of any of claims 1-6, wherein the force sensor (406, 502, 916) is formed on the mating surface (204, 302, 504) of the dock (204, 404, 506, 904) for detecting shear force; or
wherein the force sensor (406, 502, 916) is formed on a bottom surface (510) of the dock (204, 404, 506, 904); or
wherein the force sensor (406, 502, 916) is formed on a wall of the dock (204, 404, 506, 904).

8. The system (200, 300, 900) according to any of claims 1-7, wherein the dock (204, 404, 506, 904) further comprises an inertial measurement unit (IMU) sensor.

9. A method of tracking docking and undocking of a tablet computer (100, 202, 402, 512, 700, 902) from a dock (204, 404, 506, 904), the method comprising:
determining a force or pressure distribution from one or more force sensors (406, 502, 916) interfaced, directly or indirectly, with the tablet computer (100, 202, 402, 512, 700, 902);
determining a change from an initial position of the tablet computer (100, 202, 402, 512, 700, 902) by detecting a change in the force or pressure distribution detected by the one or more force sensors (406, 502, 916); and
based on the determination of the change, releasing the tablet computer (100, 202, 402, 512, 700, 902) from the dock (204, 404, 506, 904) by modifying a state of electropermanent magnets located on the dock (204, 404, 506, 904);
wherein the one or more force sensors (406, 502, 916) comprise one or more strain gauges, the one or more strain gauges being configured to perform measurements indicative of undocking of the tablet computer (100, 202, 402, 512, 700, 902) from the dock (204, 404, 506, 904) and docking of the tablet computer (100, 202, 402, 512, 700, 902) with the dock (204, 404, 506, 904).

10. The method of claim 9, wherein the tablet computer further comprises an inertial measurement unit (IMU) sensor, wherein the IMU sensor is formed within the tablet computer (100, 202, 402, 512, 700, 902) for detecting a change in orientation of the tablet computer (100, 202, 402, 512, 700, 902).

11. The method of any of claims 9-10, wherein the tablet computer (100, 202, 402, 512, 700, 902) further comprises a barometer for detecting squeezing or changes in air pressure within the tablet computer when the tablet computer is grasped and lifted.

12. The method of any of claims 9-11, wherein detecting the change in force or pressure distribution comprises comparing a measured force with a stored predefined force value.

13. The method of any of claims 9-12, wherein the method comprises measuring, by the one or more force sensors (406, 502, 916), a deformation of the dock (204, 404, 506, 904) equal to a combination of a weight of an electronic device and an attractive force of the electropermanent magnets of the dock (204, 404, 506, 904) and/or magnets of the electronic device when the electronic device is docked, and a deformation of the dock in an opposite direction during undocking of the electronic device.

14. The method of claim 13, wherein detecting the change in the force or pressure distribution detected by the one or more force sensors (406, 502, 916) the method comprises measuring a difference between the deformation when the electronic device is docked and during undocking of the electronic device.

## Patentansprüche

1. Tablet-Dock-System (200, 300, 900), umfassend:
ein Dock (204, 404, 506, 904), wobei das Dock Folgendes umfasst:
ein Dockgehäuse;
eine Kontaktfläche (204, 302, 504), die durch das Dockgehäuse gebildet ist und konfiguriert ist, um einen Tablet-Computer (100, 202, 402, 512, 700, 902) abnehmbar mit dem Tablet-Dock-System (200, 300, 900) anzudocken; und
einen Kraftsensor (406, 502, 916), umfassend einen Dehnungsmessstreifen, der an dem Dockgehäuse befestigt ist, wobei der Dehnungsmessstreifen konfiguriert ist, um Messungen durchzuführen, die Abdocken des Tablet-Computers (100, 202, 402, 512, 700, 902) von dem Dock (204, 404, 506, 904) und Andocken des Tablet-Computers (100, 202, 402, 512, 700, 902) an das Dock (204, 404, 506, 904) angeben;
einen oder mehrere Prozessoren, die basierend auf einer oder mehreren von dem Dehnungsmessstreifen empfangener Messungen bestimmen, ob das Tablet angedockt oder abgedockt wird;
einen oder mehrere Elektropermanentmagnete, die sich an dem Dock (204, 404, 506, 904) befinden, wobei das System den Tablet-Computer (100, 202, 402, 512, 700, 902) aus dem Dock (204, 404, 506, 904) freigibt, indem es einen Zustand des einen oder der mehreren Elektropermanentmagnete basierend auf der einen oder den mehreren von dem Dehnungsmessstreifen empfangenen Messungen ändert.

2. System (200, 300, 900) nach Anspruch 1, wobei der Kraftsensor (406, 502, 916) konfiguriert ist, um eine Verformung des Docks (204, 404, 506, 904), die einer Kombination aus einem Gewicht einer elektronischen Vorrichtung und einer Anziehungskraft der Elektropermanentmagnete des Docks (204, 404, 506, 904) und/oder der Magnete der elektronischen Vorrichtung entspricht, wenn die elektronische Vorrichtung angedockt ist, und eine Verformung des Docks (204, 404, 506, 904) in entgegengesetzter Richtung während des Abdockens der elektronischen Vorrichtungen zu messen.

3. System (200, 300, 900) nach Anspruch 2, wobei das System konfiguriert ist, um beim Messen einer Differenz zwischen der Verformung, wenn die elektronische Vorrichtung angedockt ist und während des Abdockens der elektronischen Vorrichtung, ein Abdockereignis auszulösen.

4. System (200, 300, 900) nach einem der Ansprüche 1-3, wobei sich der Dehnungsmessstreifen auf der Kontaktfläche (204, 302, 504) des Docks (204, 404, 506, 904) befindet, um eine Scherkraft zu detektieren, oder
wobei sich der Dehnungsmessstreifen auf einer unteren Fläche (510) des Docks (204, 404, 506, 904) befindet.

5. System (200, 300, 900) nach einem der Ansprüche 1-4, umfassend vier Dehnungsmessstreifen, die auf einer unteren Fläche (510) des Docks oder auf einer Kontaktfläche (204, 302, 504) des Docks gebildet sind.

6. System nach Anspruch 5, wobei die vier Dehnungsmessstreifen eine Wheatstone-Vollbrücken-Schaltung bilden, sodass eine Ausgangsspannung eine Verformung der Dehnungsmessstreifen angibt, die dem Tablet-Computer (100, 202, 402, 512, 700, 902) an das Dock (204, 404, 506, 904) andockt oder von diesem abdockt.

7. System (200, 300, 900) nach einem der Ansprüche 1-6, wobei der Kraftsensor (406, 502, 916) auf der Kontaktfläche (204, 302, 504) des Docks (204, 404, 506, 904) gebildet ist, um eine Scherkraft zu detektieren, oder
wobei der Kraftsensor (406, 502, 916) an einer unteren Fläche (510) des Docks (204, 404, 506, 904) gebildet ist; oder
wobei der Kraftsensor (406, 502, 916) an einer Wand des Docks (204, 404, 506, 904) gebildet ist.

8. System (200, 300, 900) nach einem der Ansprüche 1-7, wobei das Dock (204, 404, 506, 904) ferner einen Trägheitsmesseinheitssensor (inertial measurement unit - IMU) umfasst.

9. Verfahren zum Verfolgen des Andockens und Abdockens eines Tablet-Computers (100, 202, 402, 512, 700, 902) an bzw. von einem Dock (204, 404, 506, 904), wobei das Verfahren Folgendes umfasst:
Bestimmen einer Kraft- oder Druckverteilung aus einem oder mehreren Kraftsensoren (406, 502, 916), die direkt oder indirekt mit dem Tablet-Computer (100, 202, 402, 512, 700, 902) verbunden sind;
Bestimmen einer Änderung gegenüber einer Ausgangsposition des Tablet-Computers (100, 202, 402, 512, 700, 902) durch Detektieren einer Änderung der Kraft- oder Druckverteilung, die durch den einen oder die mehreren Kraftsensoren (406, 502, 916) detektiert wird; und
basierend auf der Bestimmung der Änderung, Freigeben des Tablet-Computers (100, 202, 402, 512, 700, 902) aus dem Dock (204, 404, 506, 904) durch Ändern des Zustands von Elektropermanentmagneten, die sich an dem Dock (204, 404, 506, 904) befinden;
wobei der eine oder die mehreren Kraftsensoren (406, 502, 916) einen oder mehrere Dehnungsmessstreifen umfassen, wobei der eine oder die mehreren Dehnungsmessstreifen konfiguriert sind, um Messungen durchzuführen, die Abdocken des Tablet-Computers (100, 202, 402, 512, 700, 902) von dem Dock (204, 404, 506, 904) und Andocken des Tablet-Computers (100, 202, 402, 512, 700, 902) an das Dock (204, 404, 506, 904) angeben.

10. Verfahren nach Anspruch 9, wobei der Tablet-Computer ferner einen Trägheitsmesseinheitssensor (IMU) umfasst, wobei der IMU-Sensor innerhalb des Tablet-Computers (100, 202, 402, 512, 700, 902) gebildet ist, um eine Änderung der Ausrichtung des Tablet-Computers (100, 202, 402, 512, 700, 902) zu detektieren.

11. Verfahren nach den Ansprüchen 9-10, wobei der Tablet-Computer (100, 202, 402, 512, 700, 902) ferner ein Barometer umfasst, um ein Zusammendrücken oder Änderungen des Luftdrucks innerhalb des Tablet-Computers zu detektieren, wenn der Tablet-Computer ergriffen und angehoben wird.

12. Verfahren nach den Ansprüchen 9-11, wobei das Detektieren der Änderung der Kraft- oder Druckverteilung Vergleichen einer gemessenen Kraft mit einem gespeicherten, vordefinierten Kraftwert umfasst.

13. Verfahren nach den Ansprüchen 9-12, wobei das Verfahren das Messen einer Verformung des Docks (204, 404, 506, 904), die einer Kombination aus einem Gewicht einer elektronischen Vorrichtung und einer Anziehungskraft der Elektropermanentmagnete des Docks (204, 404, 506, 904) und/oder der Magnete der elektronischen Vorrichtung entspricht, wenn die elektronische Vorrichtung angedockt ist, und einer Verformung des Docks in entgegengesetzter Richtung während des Abdockens der elektronischen Vorrichtungen durch den einen oder die mehreren Kraftsensoren (406, 502, 916) umfasst.

14. Verfahren nach Anspruch 13, wobei das Detektieren der Änderung der durch den einen oder die mehreren Kraftsensoren (406, 502, 916) detektierten Kraft- oder Druckverteilung das Messen einer Differenz zwischen der Verformung, wenn die elektronische Vorrichtung angedockt ist, und während des Abdockens der elektronischen Vorrichtung umfasst.

## Revendications

1. Système de station d'accueil de tablette (200, 300, 900) comprenant :
une station d'accueil (204, 404, 506, 904), la station d'accueil comprenant :
un boîtier de station d'accueil ;
une surface de contact (204, 302, 504) formée par le boîtier de station d'accueil configurée pour permettre à une tablette (100, 202, 402, 512, 700, 902) d'être connectée de manière amovible au système de station d'accueil de tablette (200, 300, 900) ; et
un capteur de force (406, 502, 916) comprenant une jauge de contrainte fixée au boîtier de station d'accueil, la jauge de contrainte étant configurée pour effectuer des mesures indicatives de la déconnexion de la tablette (100, 202, 402, 512, 700, 902) de la station d'accueil (204, 404, 506, 904) et de la connexion de la tablette (100, 202, 402, 512, 700, 902) à la station d'accueil (204, 404, 506, 904) ;
un ou plusieurs processeurs qui déterminent si la tablette est en train de se connecter ou de se déconnecter sur la base d'une ou de plusieurs mesures reçues de la jauge de contrainte ;
un ou plusieurs aimants électropermanents situés sur la station d'accueil (204, 404, 506, 904), dans lequel le système libère la tablette (100, 202, 402, 512, 700, 902) de la station d'accueil (204, 404, 506, 904) en modifiant un état des un ou plusieurs aimants électropermanents sur la base des une ou plusieurs mesures reçues de la jauge de contrainte.

2. Système (200, 300, 900) selon la revendication 1, dans lequel le capteur de force (406, 502, 916) est configuré pour mesurer une déformation de la station d'accueil (204, 404, 506, 904) égale à une combinaison du poids d'un dispositif électronique et d'une force d'attraction des aimants électropermanents de la station d'accueil (204, 404, 506, 904) et/ou des aimants du dispositif électronique lorsque le dispositif électronique est connecté, et une déformation de la station d'accueil (204, 404, 506, 904) dans une direction opposée lors de la déconnexion du dispositif électronique.

3. Système (200, 300, 900) selon la revendication 2, dans lequel le système est configuré pour déclencher un événement de déconnexion lors de la mesure d'une différence entre la déformation lorsque le dispositif électronique est connecté et lors de la déconnexion du dispositif électronique.

4. Système (200, 300, 900) selon l'une quelconque des revendications 1 à 3, dans lequel la jauge de contrainte est située sur la surface de contact (204, 302, 504) de la station d'accueil (204, 404, 506, 904) pour détecter la force de cisaillement, ou
dans lequel la jauge de contrainte est située sur une surface inférieure (510) de la station d'accueil (204, 404, 506, 904).

5. Système (200, 300, 900) selon l'une quelconque des revendications 1 à 4, comprenant quatre jauges de contrainte formées sur une surface inférieure (510) de la station d'accueil ou sur une surface de contact (204, 302, 504) de la station d'accueil.

6. Système selon la revendication 5, dans lequel les quatre jauges de contrainte forment un circuit en pont complet de Wheatstone de sorte qu'une tension de sortie indique une déformation des jauges de contrainte correspondant à la connexion et à la déconnexion de la tablette (100, 202, 402, 512, 700, 902) de la station d'accueil (204, 404, 506, 904).

7. Système (200, 300, 900) selon l'une quelconque des revendications 1 à 6, dans lequel le capteur de force (406, 502, 916) est formé sur la surface de contact (204, 302, 504) de la station d'accueil (204, 404, 506, 904) pour détecter une force de cisaillement ; ou
dans lequel le capteur de force (406, 502, 916) est formé sur une surface inférieure (510) de la station d'accueil (204, 404, 506, 904) ; ou
dans lequel le capteur de force (406, 502, 916) est formé sur une paroi de la station d'accueil (204, 404, 506, 904).

8. Système (200, 300, 900) selon l'une quelconque des revendications 1 à 7, dans lequel la station d'accueil (204, 404, 506, 904) comprend également un capteur d'unité de mesure inertielle (IMU).

9. Procédé de suivi de la connexion et de la déconnexion d'une tablette (100, 202, 402, 512, 700, 902) d'une station d'accueil (204, 404, 506, 904), le procédé comprenant :
la détermination d'une répartition de force ou de pression à partir d'un ou de plusieurs capteurs de force (406, 502, 916) interfacés, directement ou indirectement, avec la tablette (100, 202, 402, 512, 700, 902) ;
la détermination d'un changement par rapport à une position initiale de la tablette (100, 202, 402, 512, 700, 902) en détectant un changement dans la répartition de force ou de pression détectée par les un ou plusieurs capteurs de force (406, 502, 916) ; et
sur la base de la détermination du changement, la libération de la tablette (100, 202, 402, 512, 700, 902) de la station d'accueil (204, 404, 506, 904) en modifiant un état des aimants électropermanents situés sur la station d'accueil (204, 404, 506, 904) ;
dans lequel les un ou plusieurs capteurs de force (406, 502, 916) comprennent une ou plusieurs jauges de contrainte, les une ou plusieurs jauges de contrainte étant configurées pour effectuer des mesures indicatives de la déconnexion de la tablette (100, 202, 402, 512, 700, 902) de la station d'accueil (204, 404, 506, 904) et de la connexion de la tablette (100, 202, 402, 512, 700, 902) à la station d'accueil (204, 404, 506, 904) .

10. Procédé selon la revendication 9, dans lequel la tablette comprend également un capteur d'unité de mesure inertielle (IMU), dans lequel le capteur IMU est formé à l'intérieur de la tablette (100, 202, 402, 512, 700, 902) pour détecter un changement d'orientation de la tablette (100, 202, 402, 512, 700, 902) .

11. Procédé selon l'une quelconque des revendications 9 à 10, dans lequel la tablette (100, 202, 402, 512, 700, 902) comprend également un baromètre pour détecter la compression ou les changements de pression d'air à l'intérieur de la tablette lorsque la tablette est saisie et soulevée.

12. Procédé selon l'une quelconque des revendications 9 à 11, dans lequel la détection du changement de répartition de force ou de pression comprend la comparaison d'une force mesurée avec une valeur de force prédéfinie stockée.

13. Procédé selon l'une quelconque des revendications 9 à 12, dans lequel le procédé comprend la mesure, par les un ou plusieurs capteurs de force (406, 502, 916), d'une déformation de la station d'accueil (204, 404, 506, 904) égale à une combinaison du poids d'un dispositif électronique et d'une force d'attraction des aimants électropermanents de la station d'accueil (204, 404, 506, 904) et/ou des aimants du dispositif électronique lorsque le dispositif électronique est connecté, et d'une déformation de la station d'accueil dans une direction opposée lors de la déconnexion du dispositif électronique.

14. Procédé selon la revendication 13, dans lequel la détection du changement dans la répartition de force ou de pression détectée par les un ou plusieurs capteurs de force (406, 502, 916), le procédé comprend la mesure d'une différence entre la déformation lorsque le dispositif électronique est connecté et lors de la déconnexion du dispositif électronique.
